# EUROPEAN PATENT APPLICATION

(11) **EP 3 654 046 A1**
(43) Date of publication of application: **20.05.2020**
(21) Application number: 19208921.7
(22) Date of filing: 13.11.2019
(51) Int. Cl.: G01R 31/28, H01L 21/66

(54) **NON-DESTRUCTIVE INSPECTION SYSTEM FOR DETECTING DEFECTS IN COMPOUND SEMICONDUCTOR WAFER AND METHOD OF OPERATING THE SAME**

(30) Priority: 13.11.2018 KR 20180139126
(71) Applicant: Samsung Electronics Co., Ltd., Gyeonggi-do 16677 (KR)
(72) Inventor: Lee, Sangmin, 16677 Suwon-si, Gyeonggi-do (KR); Jung, Jinwook, 16677 Suwon-si, Gyeonggi-do (KR)
(74) Representative: Gulde & Partner

(57) **Abstract**

Provided are a non-destructive inspection system for detecting the absence or presence of an internal defect of a semiconductor wafer and a location of the internal defect in a non-destructive manner without physically deforming the semiconductor wafer, and a method of operating the non-destructive inspection system. Also provided are a non-destructive inspection system for inspecting response characteristics with respect to X-rays or gamma-rays , and a method of operating the non-destructive inspection system.

## Description

### BACKGROUND

### 1. Field

The disclosure relates to non-destructive inspection systems for detecting defects in a compound semiconductor wafer and methods of operating the non-destructive inspection systems. More particularly, the disclosure relates to systems and methods of detecting, in a non-destructive manner, the absence or presence of defects and locations of the defects in a compound semiconductor wafer that is used as a raw material of a photon counting detector (PCD), and inspecting response characteristics.

### 2. Description of Related Art

Because a compound semiconductor material that is used as a raw material of a PCD has a low thermal conductivity, an ingot of the compound semiconductor material may be grown using a traveling heater method (THM), a Bridgeman method, or the like, by which the material is placed into a quartz ampoule and heated to a high temperature (e.g., above 900°C). Various types of defects such as point defects or extended defects may occur during growth of the ingot. These defects may hinder the movement of charges generated by photons that are incident on a semiconductor wafer cut from an ingot, and cause adverse effects such as increased leakage current and lower charge collection efficiency of a PCD that is produced from the semiconductor wafer.

Recently, various methods such as infrared (IR) transmission microscopy, surface etching, X-ray topography (XRT), a cathodoluminescence (CL) technique, transmission electron microscopy (TEM), etc. have been used to detect defects in a semiconductor wafer. However, the above methods might not be capable of being reused due to deformation of a measurement sample in order to observe an internal structure of a semiconductor wafer. Further, the above methods have limitations on identifying defects in a semiconductor wafer cut from an ingot due to a high level of absorption of X-rays and gamma rays in a semiconductor material. Furthermore, these structural defects may occur more irregularly inwards from a surface of the semiconductor wafer towards the inside thereof. Thus, even when defects are found on the surface of the semiconductor wafer, some problems may occur due to unidentified defects when an actual detector is manufactured.

IR transmission microscopy, which is a currently available method of detecting defects in a semiconductor wafer, enables the detection of point defects but might not be suitable for detecting extended defects. An XRT method enables experiments to be performed in an expensive high-energy synchrotron and allows observation of defects on a surface of a semiconductor wafer in a reflection mode, and might not allow measurement of the defects in a transmission mode due to high absorption of X-rays in a semiconductor material. The CL technique enables detection of defects on the surface of a semiconductor wafer, and measurement in a vacuum environment, a cryogenic environment, or the like. Furthermore, a semiconductor sample may need to be cut to be placed in a vacuum chamber. A TEM technique enables measurement in a vacuum environment, may require a specimen with a thickness of several nanometers (nms), and allows observation across an area of several tens of micrometers (µms). As described above, these methods may include preprocessing of a semiconductor wafer and allow observation of the surface of the semiconductor wafer or measurement of a portion thereof, and thus, these methods have a problem in that a detector that performs differently than as expected is manufactured when an actual semiconductor wafer is used.

### SUMMARY

Provided are a non-destructive inspection system for detecting the absence or presence of defects and locations of the defects in a semiconductor wafer in a non-destructive manner without physically deforming the semiconductor wafer, and a method of operating the non-destructive inspection system.

Also provided are a non-destructive inspection system for inspecting response characteristics with respect to X-rays or gamma-rays , and a method of operating the non-destructive inspection system.

Additional aspects will be set forth in part in the description which follows and, in part, will be apparent from the description, or may be learned by practice of the presented embodiments of the disclosure.

According to an aspect of the disclosure, a inspection system for detecting a defect in a semiconductor wafer including a compound semiconductor material, the inspection system includes an electrode provided on a first surface of the semiconductor wafer; a voltage source configured to generate an electric field by applying a high voltage bias to the semiconductor wafer via the electrode; a light source configured to irradiate the first surface of the semiconductor wafer with light to generate charges in the semiconductor wafer; a plurality of probes disposed on a second surface of the semiconductor wafer and configured to respectively detect the charges based on movement of electrons and holes generated in the semiconductor wafer by the light irradiated by the light source; and a controller configured to: measure amounts of the charges respectively detected by the plurality of probes; compare the amounts of the charges with a predetermined threshold; and detect a defect in the semiconductor wafer based on comparing the amounts of the charges with the predetermined threshold.

The controller may include an application specific integrated circuit (ASIC) configured to measure the amounts of the charges on a pixel-by-pixel basis; compare the amounts of the charges with the predetermined threshold on the pixel-by-pixel basis; and generate digital signals based on comparing the amounts of the charges with the predetermined threshold on the pixel-by-pixel basis. The controller may also include a processor configured to generate a wafer feature map identifying a location of the defect in the semiconductor wafer based on the digital signals generated on the pixel-by-pixel basis.

Each of the plurality of probes may have a same size as a size of a unit pixel of the semiconductor wafer.

The plurality of probes may be detachable from the second surface of the semiconductor wafer.

The plurality of probes may be provided on an entire second surface of the semiconductor wafer, and the plurality of probes may be configured to detect the charges over an entire region of the semiconductor wafer corresponding to the entire second surface of the semiconductor wafer.

The plurality of probes may have a predetermined number of probes configured to detect the charges in a region corresponding to an area of a unit chip of the semiconductor wafer, and the predetermined number of probes constitutes a probe array.

The probe array may be configured to detect the charges based on being moved along the second surface of the semiconductor wafer in a direction parallel to a longitudinal direction of the semiconductor wafer.

The electrode may have a size corresponding to an area of a unit chip of the semiconductor wafer, and the plurality of probes may be configured to have a predetermined number of probes to detect the charges in a region corresponding to the area of the unit chip.

The electrode may be configured to be moved on the first surface of the semiconductor wafer by a distance corresponding to the area of the unit chip in a direction parallel to a longitudinal direction of the semiconductor wafer, and the plurality of probes may be configured to detect the charges on the second surface of the semiconductor wafer based on being moved in a same direction and by a same distance that the electrode is moved to be aligned with a position of the electrode.

The controller may be configured to generate energy spectrum data representing a degree of a response to a photon having a specific energy band.

The controller may be configured to generate the energy spectrum data acquired via the plurality of probes on a pixel-by-pixel basis.

The controller may be configured to generate energy spectrum data of an entire region of the semiconductor wafer by summing the energy spectrum data acquired via the plurality of probes.

According to an aspect of the disclosure, a inspection method of detecting a defect in a semiconductor wafer including a compound semiconductor material includes irradiating a first surface of the semiconductor wafer with light; generating an electric field in the semiconductor wafer by applying a high voltage (HV) bias via an electrode disposed on the first surface of the semiconductor wafer; detecting, via a plurality of probes, charges based on movement of electrons and holes generated in the semiconductor wafer; measuring amounts of the charges; comparing the amounts of the charges with a predetermined threshold; and detecting a defect in the semiconductor wafer based on comparing the amounts of the charges with the predetermined threshold.

The measuring amounts of the detected charges comprises measuring amounts of the detected charges on a pixel-by-pixel basis, and the detecting the defect in the semiconductor wafer may include generating digital signals based on comparing the amounts of the charges with the predetermined threshold; and generating a wafer feature map identifying a location of the defect in the semiconductor wafer based on the digital signals.

The plurality of probes may be configured to have a predetermined number of probes configured to detect the charges in a region corresponding to an area of a unit chip of the semiconductor wafer, and the predetermined number of probes may constitute a probe array.

The detecting the charges may include detecting a first subset of the charges in a first region of the semiconductor wafer; moving the probe array to a second region on a second surface of the semiconductor wafer in a direction parallel to a longitudinal direction of the semiconductor wafer; and detecting a second subset of the charges in the second region of the semiconductor wafer.

The electrode may have a size corresponding to an area of a unit chip of the semiconductor wafer, and the plurality of probes may have a predetermined number of probes configured to detect the charges in a region corresponding to the area of the unit chip.

The detecting the charges may include moving the electrode on the first surface of the semiconductor wafer by a distance corresponding to the area of the unit chip in a direction parallel to a longitudinal direction of the semiconductor wafer; moving the plurality of probes in a same direction and by a same distance that the electrode is moved to be aligned with a position of the electrode; and detecting the charges in the semiconductor wafer via the plurality of probes based on moving the plurality of probes.

The method may include generating energy spectrum data representing a degree of an energy response in a specific energy band.

According to an aspect of the disclosure, computer program product comprising a computer-readable storage medium, wherein the computer-readable storage medium may include instructions for performing a inspection method including: irradiating, via a light source, a first surface of a semiconductor wafer with light; generating an electric field in the semiconductor wafer by applying a high voltage (HV) bias via an electrode disposed on the first surface of the semiconductor wafer; detecting, via a plurality of probes, charges based on movement of electrons and holes generated in the semiconductor wafer; measuring amounts of the charges; comparing the amounts of the charges with a predetermined threshold; and detecting a defect in the semiconductor wafer based on comparing the amounts of the charges with the predetermined threshold.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is an external view illustrating a configuration of a non-destructive inspection system according to an embodiment;
FIG. 2A is a conceptual diagram for explaining a principle of a non-destructive inspection system detecting a defect by measuring charges in a semiconductor wafer, according to an embodiment;
FIG. 2B is a graph showing the amounts of charges measured via a plurality of probes according to an embodiment;
FIG. 3A is a cross-sectional view of a non-destructive inspection system according to an embodiment;
FIG. 3B is a cross-sectional view of a non-destructive inspection system according to an embodiment;
FIG. 4 is a cross-sectional view of a non-destructive inspection system according to an embodiment;
FIG. 5 is a flowchart illustrating operations of a non-destructive inspection method according to an embodiment;
FIG. 6A is a bottom view illustrating a method, performed by a non-destructive inspection system positioned on a bottom surface of a semiconductor wafer, of detecting an internal defect of the semiconductor wafer, according to an embodiment;
FIG. 6B is a cross-sectional view of the non-destructive inspection system and the semiconductor wafer corresponding to FIG. 6A according to an embodiment;
FIG. 7 is a flowchart illustrating operations of a non-destructive inspection method according to an embodiment;
FIG. 8 is a cross-sectional view for explaining a method, performed by a non-destructive inspection system, of detecting an internal defect of a semiconductor wafer while moving over a bottom surface of the semiconductor wafer, according to an embodiment;
FIG. 9 is a flowchart illustrating operations of a method, performed by a non-destructive inspection system, of detecting an internal defect of a semiconductor wafer while moving over the bottom surface of the semiconductor wafer, according to an embodiment;
FIG. 10 illustrates a wafer feature map generated by a non-destructive inspection system to represent a location of an internal defect of a semiconductor wafer, according to an embodiment;
FIG. 11A illustrates energy spectrum data generated by a non-destructive inspection system to represent an energy response of a unit chip of a semiconductor wafer, according to an embodiment;
FIG. 11B illustrates energy spectrum data of each unit chip shown in FIG. 11A according to an embodiment; and
FIG. 12 is a cross-sectional view illustrating a configuration of a non-destructive inspection system according to an embodiment.

### DETAILED DESCRIPTION

The present disclosure provides example embodiments to clarify the scope of the disclosure and to allow those of ordinary skill in the art to implement the embodiments of the disclosure. The embodiments of the disclosure may have different forms.

Throughout the disclosure, the expression "at least one of a, b, or c" may indicate only a, only b, only c, both a and b, both a and c, both b and c, all of a, b, and c, or variations thereof.

Like reference numerals may refer to like elements throughout the present disclosure. The present disclosure may not describe all components in the embodiments of the disclosure, and common knowledge in the art or redundant descriptions of the embodiments of the disclosure may be omitted below. The terms "part" and "portion" as used herein may be implemented using software, hardware, or a combination thereof. According to embodiments of the disclosure, a plurality of "parts" or "portions" may be embodied as a single unit or a single element. Alternatively, a single "part" or "portion" may include a plurality of units or a plurality of elements. Hereinafter, operation principles and embodiments of the disclosure will be described in detail with reference to the accompanying drawings.

In the present specification, a "defect" may generically refer to a physical irregularity in a semiconductor wafer, a charging region on a surface of the semiconductor wafer, a change in a surface chemical, a change in semiconductor doping concentration, a contaminant in the semiconductor wafer, a metallic or organic contaminant on the surface of the semiconductor wafer, etc.

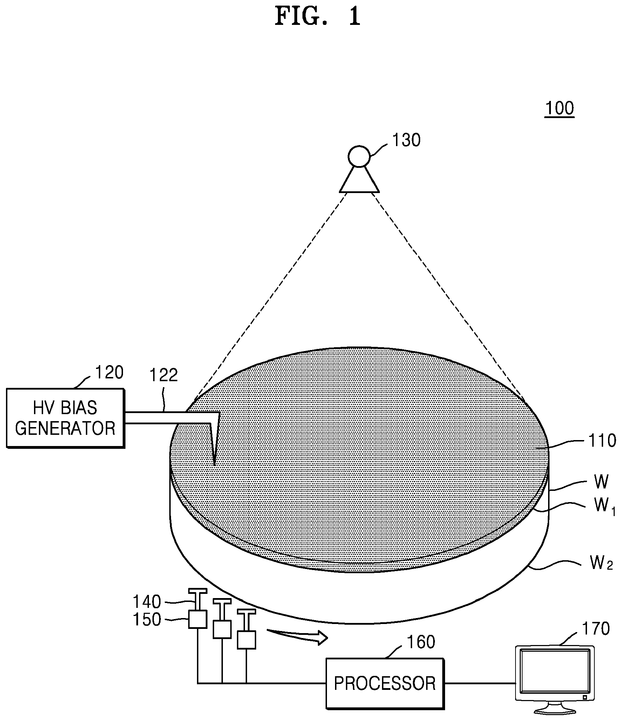

FIG. 1 is an external view illustrating a configuration of a non-destructive inspection system 100 according to an embodiment of the disclosure.

Referring to FIG. 1, the non-destructive inspection system 100 may be a system for detecting an internal defect of a semiconductor wafer W in a non-destructive manner. For example, the non-destructive inspection system 100 may detect an internal defect of the semiconductor wafer W without causing physical or chemical damage or other effects to the semiconductor wafer W. In this case, the semiconductor wafer W may be a compound semiconductor used as a raw material of a PCD. For example, the semiconductor wafer W may be a compound semiconductor including cadmium telluride (CdTe), cadmium zinc telluride (CdZnTe), cadmium tellurium selenide (CdTeSe), cadmium manganese telluride (CdMnTe), perovskite, or the like.

The non-destructive inspection system 100 may include an electrode 110, a high voltage (HV) bias generator 120, an HV application probe 122, a light source 130, a plurality of probes 140, a plurality of application specific integrated circuits (ASICs) 150, and a processor 160. According to an embodiment of the disclosure, the non-destructive inspection system 100 may further include a display 170.

The electrode 110 may be disposed on a first surface W₁ of the semiconductor wafer W on which photons are incident from the light source 130. The electrode 110 may be a common electrode commonly applied to the entire first surface W₁ of the semiconductor wafer W. The electrode 110 may function as a conducting layer attached to the first surface W₁ of the semiconductor wafer W. According to an embodiment of the disclosure, the electrode 110 may generate an electric field in the semiconductor wafer W by receiving a high voltage from the HV bias generator 120.

The HV bias generator 120 may apply a high voltage bias to the electrode 110 via the HV application probe 122. The HV bias generator 120 may generate an electric field in the semiconductor wafer W by applying a high voltage bias to the electrode 110. When a high voltage bias is applied by the HV bias generator 120, an electron-hole pair may be generated in the semiconductor wafer W, and an internal electric field may be generated due to the generated electron-hole pair. The HV bias generator 120 may include a voltage source configured to apply high voltage (e.g., voltages greater than 1000 volts, 1500 volts, etc.).

The light source 130 may irradiate with light the first surface W₁ of the semiconductor wafer W on which the electrode 110 is disposed. The light source 130 may be configured to emit light having a variable intensity or variable wavelength, and may be arranged to irradiate the semiconductor wafer W with light at a predetermined angle. The light source 130 may irradiate the first surface W₁ of the semiconductor wafer W with light for generating charges in the semiconductor wafer W. The light source 130 may irradiate the semiconductor wafer W with light of a wavelength having an energy greater than a band gap of the semiconductor wafer W. For example, the light source 130 may be an illumination source that irradiates the semiconductor wafer W with X-rays, gamma-rays, laser light, or the like. However, the type of light radiated by the light source 130 is not limited to the above examples.

According to an embodiment of the disclosure, the light source 130 may be combined with various types of optical filters to radiate light having a preset wavelength and intensity.

The probes 140 may be disposed on a second surface W₂ that is opposite to the first surface W₁ of the semiconductor wafer W. The probes 140 may detect charges based on movement of electrons and holes generated in the semiconductor wafer W based on light radiated by the light source 130. The probes 140 may be formed of a metal material having an electric conductivity. According to an embodiment of the disclosure, the probes 140 may be each composed of a liquid metal such as mercury (Hg). The probes 140 may detect charges in the semiconductor wafer W in a non-destructive manner, such as without causing physical or chemical effects such as scratches, flaws, etc. to the semiconductor wafer W. The probes 140 may be disconnected from the second surface W₂ of the semiconductor wafer W.

Each of the probes 140 may have the same size as a unit pixel of the semiconductor wafer W. According to an embodiment of the disclosure, the probes 140 may cover the entire second surface W₂ of the semiconductor wafer W, and there may be a predetermined number of the probes 140 to detect charges in the entire region of the semiconductor wafer W. However, embodiments of the disclosure are not limited thereto. According to an embodiment of the disclosure, there may be a predetermined number of the probes 140 capable of detecting charges in a region corresponding to an area of a unit chip of the semiconductor wafer W.

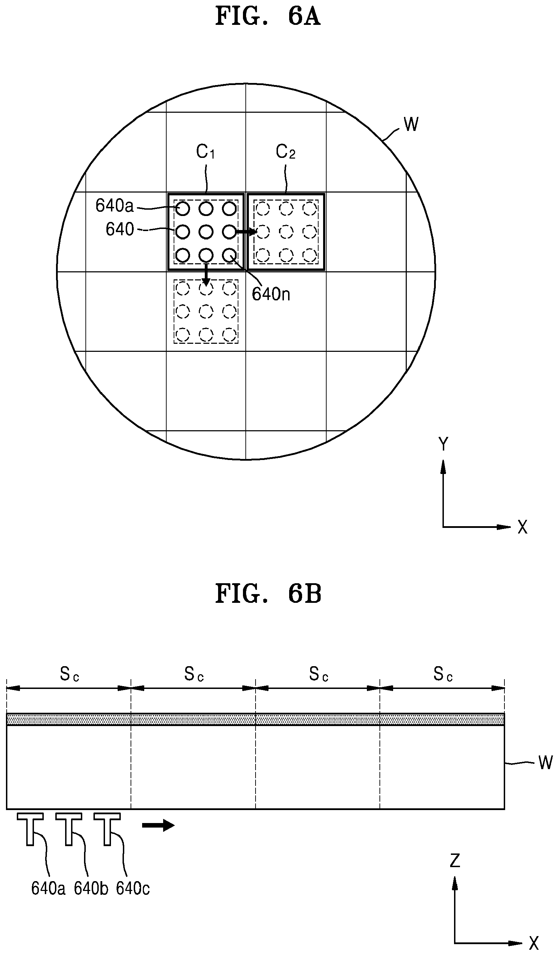

According to an embodiment of the disclosure, the probes 140 may form a probe array including a set of a predetermined number of probes. When the probes 140 form a probe array to detect charges in a region of the semiconductor wafer W instead of the entire region thereof, the probe array may detect the charges while being moved in relation to the second surface W₂ of the semiconductor wafer W, as described in more detail below with reference to FIGS. 6A, 6B, 7, and 8.

The ASICs 150 may measure amounts of charges detected by the probes 140, and generate signal values by comparing the measured amounts of charges with a predetermined threshold. For example, each of the ASICs 150 may be comprised of a capacitive sensor. According to an embodiment of the disclosure, the ASICs 150 may respectively compare analog values of the amounts of charges detected by the probes 140 with the predetermined threshold, and may convert the analog values into digital signal values to be output to the processor 160. According to an embodiment of the disclosure, the non-destructive inspection system 100 may include a number of the ASICs 150 that corresponds to a number of the probes 140, and the ASICs 150 may generate digital signal values based on the amounts of charges detected on a pixel-by-pixel basis.

Although FIG. 1 shows that the ASICs 150 are configured as a plurality of ASICs 150 to respectively correspond to the probes 140, embodiments of the disclosure are not limited thereto. According to an embodiment of the disclosure, the ASICs 150 may be configured as a single circuit.

The processor 160 may generate a wafer feature map that provides a location of a defect in the semiconductor wafer W based on digital signals generated by the ASICs 150 on a pixel-by-pixel basis. The processor 160 may be implemented as a hardware device including at least one of a central processing unit (CPU), a microprocessor, a graphic processing unit (GPU), random-access memory (RAM), or read-only memory (ROM).

The ASIC(s) 150 and the processor 160 may collectively form a controller, a microcontroller, or the like.

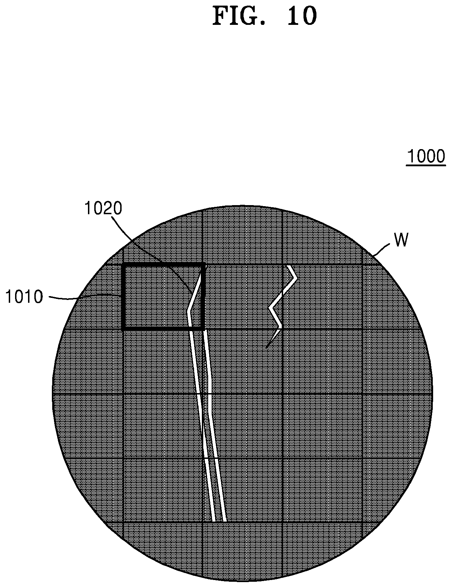

The processor 160 may generate an image based on a digital signal by using a general-purpose image processing method. The processor 160 may generate a wafer feature map that depicts a pixel corresponding to a location of a defect in the semiconductor wafer W in white, and a normal region that does not include a defect in black. The wafer feature map will be described in more detail below with reference to FIG. 10.

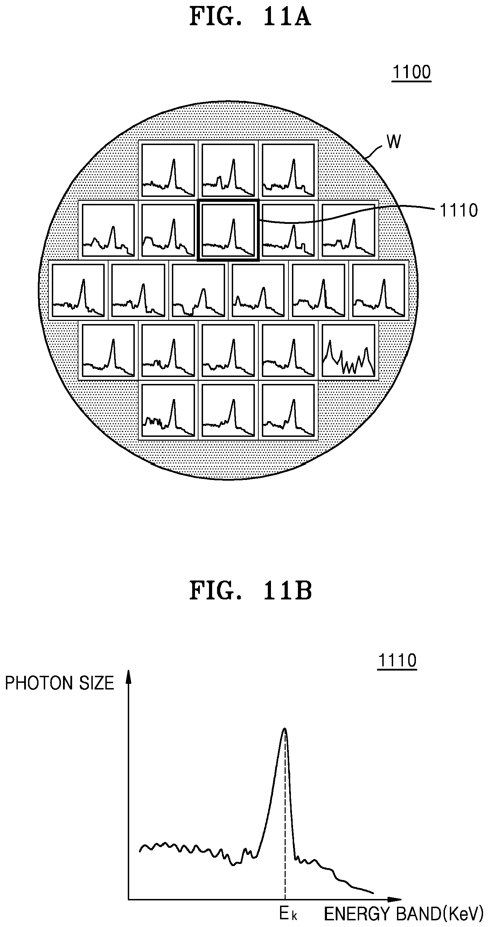

According to an embodiment of the disclosure, the processor 160 may generate energy spectrum data representing the degree of energy response to a photon with a specific energy band. The energy spectrum data will be described in more detail below with reference to FIGS. 11A and 11B.

The display 170 may display the wafer feature map generated by the processor 160. According to an embodiment of the disclosure, the display 170 may display an energy spectrum representing the degree of response to a photon with a specific energy per unit chip area or per unit pixel of the semiconductor wafer W. The display 170 may display an energy spectrum in such a manner that the energy spectrum overlaps a corresponding region on the semiconductor wafer W, as described in more detail below with reference to FIG. 11A.

In general, structural defects that are present in a compound semiconductor occur irregularly at different depths of the compound semiconductor. Because transmission of light such as X-rays is inhibited by the compound semiconductor, these defects might not be detected by using a detection method of the related art. According to an embodiment of the disclosure, the non-destructive inspection system 100 may detect the presence and/or absence of defects, and may also detect locations of the defects in the semiconductor wafer W by detecting charges generated in the semiconductor wafer W based on photons incident thereon and imaging the charges. Furthermore, according to an embodiment of the disclosure, the non-destructive inspection system 100 may perform non-destructive inspection without causing substantial physical flaws or chemical reactions to the semiconductor wafer W. Thus, the inspected semiconductor wafer W may be used as a PCD, and a portion of the semiconductor wafer W exhibiting non-uniform performance may be discarded during manufacturing, thereby providing improved production yield and cost management.

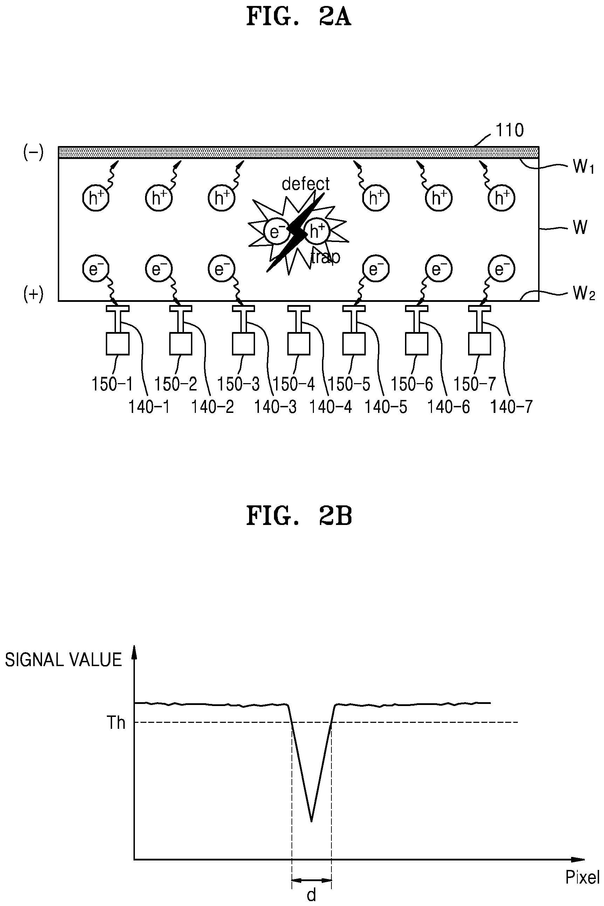

FIG. 2A is a conceptual diagram for explaining a principle of a non-destructive inspection system detecting a defect by measuring charges in a semiconductor wafer W.

Referring to FIG. 2A, when an HV bias is applied to an electrode 110, an electric potential on a surface of the semiconductor wafer W may be changed. In the embodiment of the disclosure shown in FIG. 2A, negative (-) and positive (+) electric potentials may be respectively applied to first and second surfaces W₁ and W₂ of the semiconductor wafer W. Furthermore, an electric field may be generated in the semiconductor wafer W by the HV bias applied to the electrode 110.

When light having an energy exceeding a bandgap of the semiconductor wafer W is irradiated by the light source (e.g., light source 130 of FIG. 1), carriers of electrons (e) and holes (h+) may be generated in the semiconductor wafer W. Light irradiation may also cause the carriers of electrons (e⁻) and holes (h⁺) to drift and recombine and induce population and depopulation that may affect an electric potential on the surface of the semiconductor wafer W. In this case, a plurality of probes, i.e., first through seventh probes 140-1 through 140-7, may respectively detect electrons (e⁻) on the second surface W₂ of the semiconductor wafer W.

The first through seventh probes 140-1 through 140-7 may respectively correspond to pixels in a wafer feature map generated by the processor 160. Although FIG. 2A shows that the number of the first through seventh probes 140-1 through 140-7 is seven, this is merely an example, and the number of the first through seventh probes 140-1 through 140-7 is not limited to the number shown in FIG. 2A. In the embodiment of the disclosure shown in FIG. 2A, first through third probes 140-1 through 140-3, and fifth through seventh probes 140-5 through 140-7 may respectively detect charges on the second surface W₂ of the semiconductor wafer W. However, the fourth probe 140-4 may not detect a charge, which may be indicative of the existence of a defect within the semiconductor wafer W. In detail, when there is a defect at a specific depth of the semiconductor wafer W, trapping of an electron (e⁻) and a hole (h+) occurs. Because the electron (e⁻) and hole (h+) are trapped in a defect region, the electron (e) and hole (h+) might not reach the surface of the semiconductor wafer W. For example, and as shown in FIG. 2A, the fourth probe 140-4 may fail to detect any charge.

A plurality of ASICs, i.e., first through seventh ASICs 150-1 through 150-7, may collect charge amount information respectively detected by the first through seventh probes 140-1 through 140-7, may compare the collected charge amount information with a predetermined threshold, and may convert the charge amount information into digital signals, accordingly. Although FIG. 2A shows that the first through seventh ASICs 150-1 through 150-7 are configured as a plurality of ASICs respectively corresponding to the first through seventh probes 140-1 through 140-7, a different configuration may be implemented in practice. In other words, the first through seventh ASICs 150-1 through 150-7 may be configured as a plurality of ASICs or a single ASIC chip.

In the embodiment of the disclosure shown in FIG. 2A, the fourth ASIC 150-4 connected to the fourth probe 140-4 may not collect charge amount information, or may collect charge amount information indicating a slight amount of charge. In this case, the fourth probe 140-4 may detect a part of charges of trapped electrons (e⁻), which escape from a defect region, and collect charge amount information having a small value.

FIG. 2B is a graph showing signal values obtained by converting the amounts of charges detected in pixels respectively corresponding to positions where a plurality of probes (the first through seventh probes 140-1 through 140-7 of FIG. 2A) are arranged. Signal values in the graph of FIG. 2B may be current or voltage values based on charges respectively detected by the first through seventh probes 140-1 through 140-7.

Referring to FIG. 2B, ASICs (e.g., the first through seventh ASICs 150-1 through 150-7 of FIG. 2A) may respectively compare the amounts of charges detected by the first through seventh probes 140-1 through 140-7 with a predetermined threshold Th. The first through seventh ASICs 150-1 through 150-7 may each determine that a defect exists in a region corresponding to a pixel d having a signal value less than or equal to the predetermined threshold Th among the signal values. For example, the pixel d having the signal value less than or equal to the predetermined threshold Th may be a region where the fourth probe 140-4 of FIG. 2A is located.

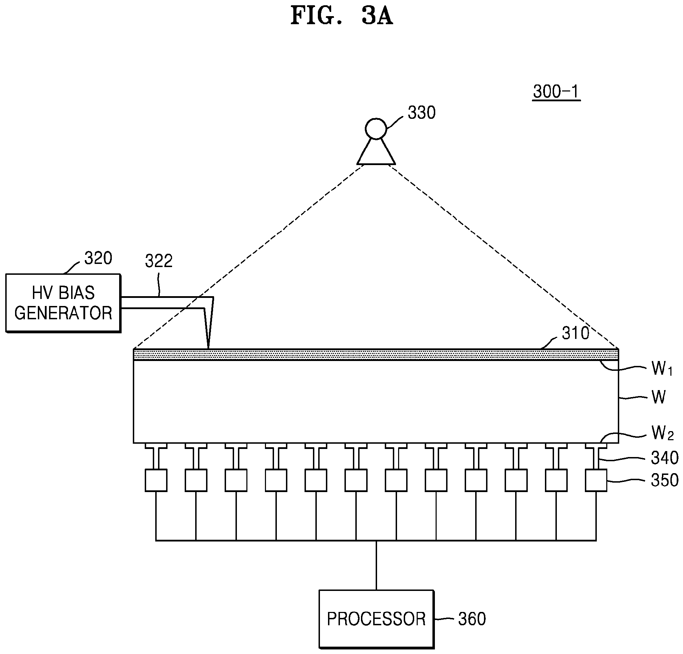

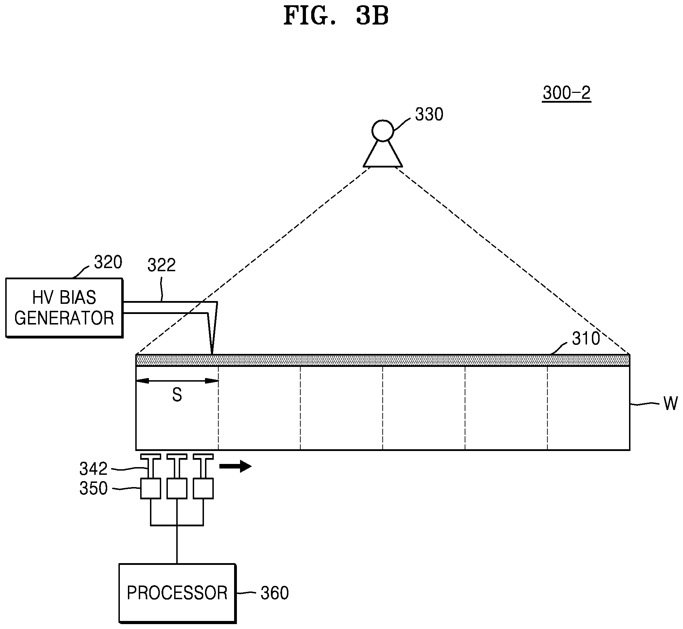

FIG. 3A is a cross-sectional view of a non-destructive inspection system 300-1 according to an embodiment of the disclosure, and FIG. 3B is a cross-sectional view of a non-destructive inspection system 300-2 according to an embodiment of the disclosure.

Referring to FIG. 3A, the non-destructive inspection system 300-1 may include an electrode 310, an HV bias generator 320, an HV application probe 322, a light source 330, a plurality of probes 340, ASICs 350, and a processor 360. The non-destructive inspection system 300-1 of FIG. 3A may have substantially the same configuration as the non-destructive inspection system 100 of FIG. 1 except for the number and arrangement of the probes 340, and thus, descriptions that have been already provided above with respect to FIG. 1 may be omitted below. In detail, the electrode 310, the HV bias generator 320, the HV application probe 322, the light source 330, and the processor 360 of the non-destructive inspection system 300-1 may respectively correspond to the electrode 110, the HV bias generator 120, the HV application probe 122, the light source 130, and the processor 160 described above with reference to FIG. 1.

In the structure of the non-destructive inspection system 300-1 shown in FIG. 3A, the probes 340 may be arranged on a second surface W₂ of a semiconductor wafer W that is opposite to a first surface W₁ thereof on which light radiated by the light source 330 is incident. The probes 340 may be disposed on the second surface W₂ of the semiconductor wafer W, and may be disconnected therefrom after the probes 340 have been connected. The non-destructive inspection system 300-1 may include a predetermined number of probes 340 to detect charges over the entire region of the semiconductor wafer W. The probes 340 may be separated from one another by a predetermined distance, and may be arranged on the entire second surface W₂ of the semiconductor wafer W.

The probes 340 may be arranged in a planar manner on the second surface W₂ of the semiconductor wafer W to form a probe array.

The ASICs 350 may be formed as a plurality of ASICs to be respectively connected to the probes 340, but are not limited thereto. The ASICs 350 may be formed as a single ASIC connected to all the probes 340.

Referring to FIG. 3B, the non-destructive inspection system 300-2 may include similar components as those shown in FIG. 3A, but is different from the non-destructive inspection system 300-1 in terms of the number and structure of a plurality of probes 342. The non-destructive inspection system 300-2 of FIG. 3B may be configured to have a predetermined number of probes 342 configured to detect charges in a region S of the semiconductor wafer W instead of the entire region thereof. While FIG. 3B depicts three probes 342, this is merely an example, and the number of probes 342 is not limited to the number shown in FIG. 3B.

According to an embodiment of the disclosure, the non-destructive inspection system 300-2 may include a predetermined number of the probes 342 to detect charges in the region S of the same area as that of a unit chip of a semiconductor wafer W. In this case, the probes 342 may be arranged such that they are separated from one another by a predetermined distance to form a probe array.

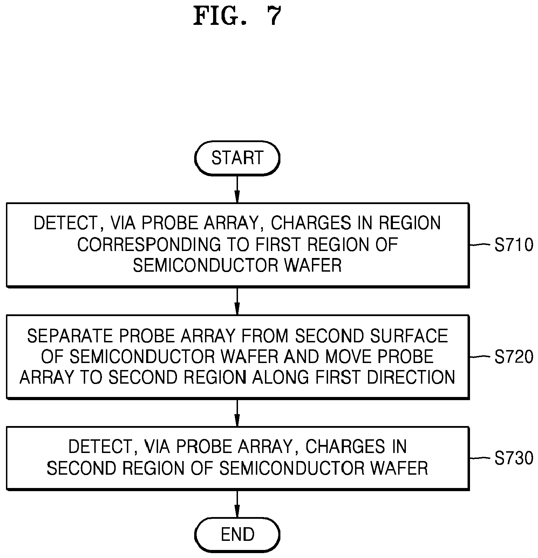

When the probes 342 are formed to have a structure in which charges might not be detected over the entire region of the semiconductor wafer W as in the embodiment of the disclosure shown in FIG. 3B, the probes 342 may form a probe array to detect charges while being moved in relation to the semiconductor wafer W, which will be described in more detail below with reference to FIGS. 6A, 6B, and 7.

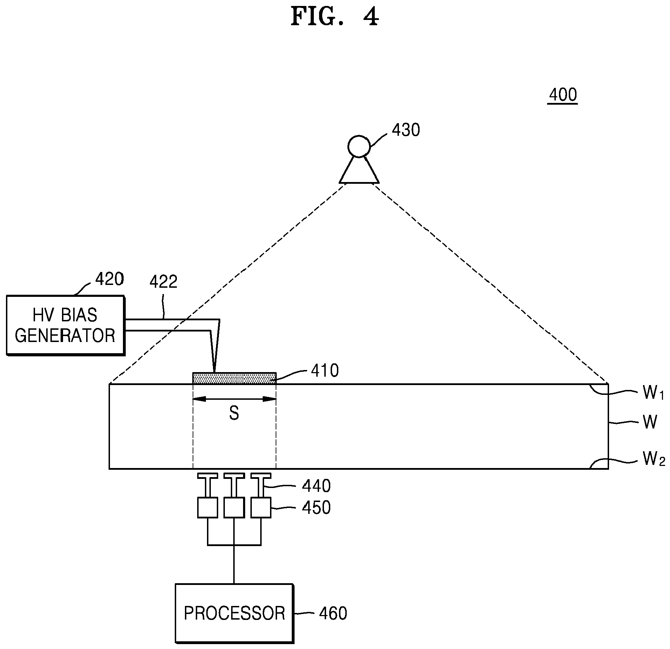

FIG. 4 is a cross-sectional view of a non-destructive inspection system 400 according to an embodiment of the disclosure.

Referring to FIG, 4, the non-destructive inspection system 400 may include an electrode 410, an HV bias generator 420, an HV application probe 422, a light source 430, a plurality of probes 440, a plurality of ASICs 450, and a processor 460. The non-destructive inspection system 400 of FIG. 4 may have substantially the same configuration as the non-destructive inspection system 100 of FIG. 1 except for the shape of the electrode 410 and the number and arrangement of the probes 440, and thus, descriptions that have already been provided above with respect to FIG. 1 may be omitted below. In detail, the HV bias generator 420, the HV application probe 422, the light source 430, and the processor 460 of the non-destructive inspection system 400 may respectively correspond to the HV bias generator 120, the HV application probe 122, the light source 130, and the processor 160 described above with reference to FIG. 1.

In the structure of the non-destructive inspection system 400 shown in FIG. 4, the electrode 410 may be formed to cover a portion of a first surface W₁ of a semiconductor wafer W instead of the entire first surface W₁ on which light irradiated by the light source 430 is incident. According to an embodiment of the disclosure, an area S of the electrode 410 may be equal to a size of a unit chip of the semiconductor wafer W. The electrode 410 may be a common electrode commonly applied to the portion of the first surface W₁ of the semiconductor wafer W. The electrode 410 may function as a conducting layer disposed on the first surface W₁ of the semiconductor wafer W.

The non-destructive inspection system 400 may include a predetermined number of probes 440 to detect charges in a portion of a surface of the semiconductor wafer W having the same size as the area S of the electrode 410. The probes 440 may be arranged to form a probe array.

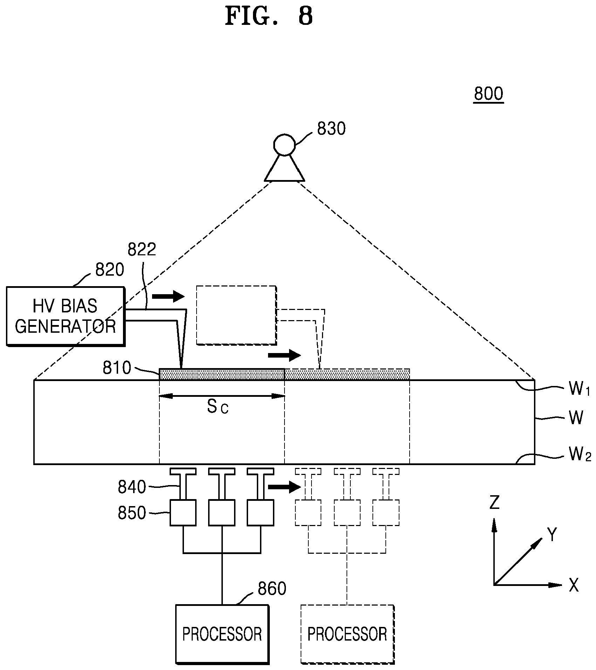

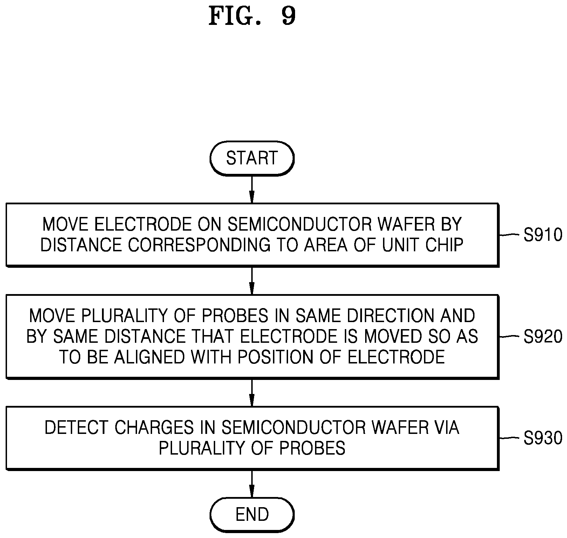

The probes 440 may be disposed on a second surface W₂ of the semiconductor wafer W in such a manner that the probes 440 are aligned with a position of the electrode 410. According to an embodiment of the disclosure, the electrode 410 may be moved along a longitudinal direction of the semiconductor wafer W, and the probes 440 may be moved to be aligned with the electrode 410. Movement of the electrode 410 and the probes 440 will be described in more detail below with reference to FIGS. 8 and 9.

The ASICs 450 may be formed as a plurality of ASICs to be respectively connected to the probes 440, but are not limited thereto. The ASICs 450 may be configured as a single ASIC connected to the probes 440.

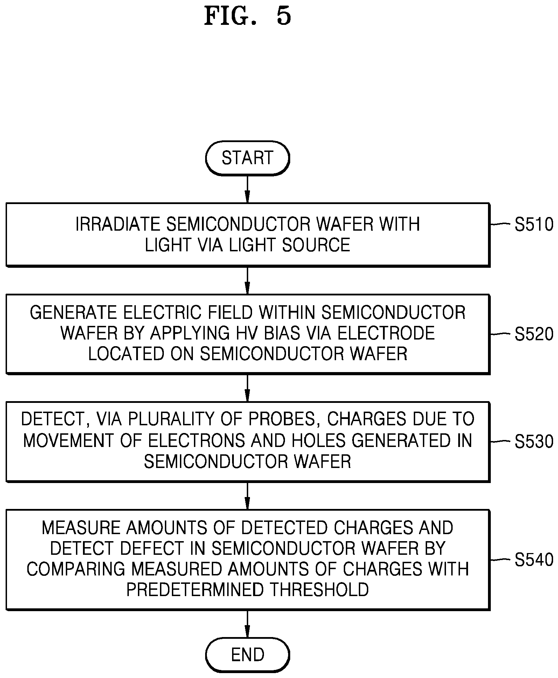

FIG. 5 is a flowchart illustrating operations of a non-destructive inspection method according to an embodiment of the disclosure.

A non-destructive inspection system irradiates a semiconductor wafer with light via a light source (S510). According to an embodiment of the disclosure, the light source may irradiate a first surface of the semiconductor wafer with light for generating charges in the semiconductor wafer. The light source may irradiate the semiconductor wafer with light of a wavelength having an energy greater than a bandgap of the semiconductor wafer. For example, the light source may be an illumination source that irradiates the semiconductor wafer with X-rays, gamma-rays, laser light, or the like.

The non-destructive inspection system generates an electric field within the semiconductor wafer by applying an HV bias via an electrode provided on the semiconductor wafer (S520). The electrode may be located on the first surface of the semiconductor wafer on which photons are incident from the light source. According to an embodiment of the disclosure, the electrode may generate an electric field in the semiconductor wafer by receiving a high voltage from an HV bias generator.

The non-destructive inspection system detects, via a plurality of probes, charges due to movement of electrons and holes generated in the semiconductor wafer (S530). According to an embodiment of the disclosure, the probes may be arranged to cover the entire surface of the semiconductor wafer and detect charges in the entire region of the semiconductor wafer. According to another embodiment of the disclosure, of the non-destructive inspection system may include a predetermined number of probes to detect charges in a region corresponding to an area of a unit chip of the semiconductor wafer. The probes may detect charges that move based on an HV bias being applied, and may collect the detected charges.

The non-destructive inspection system measures amounts of the detected charges and detects a defect in the semiconductor wafer by comparing the measured amounts of charges with a predetermined threshold (S540). According to an embodiment of the disclosure, the non-destructive inspection system may measure, via the probes, amounts of charges on the surface of the semiconductor wafer on a pixel-by-pixel basis, and compare the measured amounts of charges with a predetermined threshold to generate digital signals. The non-destructive inspection system may generate, based on the generated digital signals, a wafer feature map providing a location of an internal defect of the semiconductor wafer.

FIG. 6A is a bottom view illustrating a method, performed by a non-destructive inspection system positioned on a bottom surface of a semiconductor wafer W, of detecting an internal defect of the semiconductor wafer W, according to an embodiment of the disclosure, and FIG. 6B is a cross-sectional view of the non-destructive inspection system and the semiconductor wafer W corresponding to FIG. 6A.

Referring to FIGS. 6A and 6B, a plurality of probes 640a through 640n that is a component of the non-destructive inspection system may be disposed on the bottom surface of the semiconductor wafer W, and detect charges on the bottom surface of the semiconductor wafer W. The non-destructive inspection system may include a predetermined number of probes 640a through 640n that form a probe array 640. According to an embodiment of the disclosure, the probe array 640 may include a predetermined number of probes configured to detect charges in a region corresponding to an area S_{c} of a unit chip of the semiconductor wafer W. Although FIGS. 6A and 6B show that the probes 640a through 640n may be arranged in a 3 x 3 two-dimensional (2D) array including nine probes, the number of the probes 640a through 640n and the shape and size of an array are not limited thereto.

The probe array 640 may be disposed on the bottom surface of the semiconductor wafer W, and may be moved along the bottom surface of the semiconductor wafer W. According to an embodiment of the disclosure, the probe array 640 may move along the bottom surface of the semiconductor wafer W in a direction parallel to a longitudinal direction of the semiconductor wafer W. The non-destructive inspection system may include a device configured to move the probes 640a through 640n in the probe array 640 at a fixed height in an X-axis direction, parallel to a surface of the semiconductor wafer W, or a Y-axis direction.

The probes 640a through 640n in the probe array 640 may detect charges on the bottom surface of the semiconductor wafer W while being moved along the X-axis or Y-axis directions. According to an embodiment of the disclosure, the probes 640a through 640n may detect charges in the region corresponding to a first unit chip C₁, and may detect charges in a region corresponding to a second unit chip C₂ based on being moved in the X-axis direction. The probe array 640 may be moved in a successive manner by a distance that may correspond to the area S_{c} of a unit chip, but is not limited thereto.

FIG. 7 is a flowchart illustrating operations of a non-destructive inspection method according to an embodiment of the disclosure.

The non-destructive inspection system detects, via a probe array, charges in a region corresponding to a first region of a semiconductor wafer (S710). According to an embodiment of the disclosure, the non-destructive inspection system may include a predetermined number of probes, and the predetermined number of probes may constitute a probe array. The probe array may detect charges in the first region corresponding to an area of a unit chip of the semiconductor wafer.

The non-destructive inspection system separates the probe array from a second surface of the semiconductor wafer and moves the probe array to a second region along a first direction (S720). According to an embodiment of the disclosure, the non-destructive inspection system may move the probe array that is detached from the second surface of the semiconductor wafer. The non-destructive inspection system may move the probe array along the second surface of the semiconductor wafer in a direction parallel to a longitudinal direction of the semiconductor wafer. According to an embodiment of the disclosure, the non-destructive inspection system may iteratively move the probe array by a distance corresponding to an area of a unit chip. However, the distance by which the probe array iteratively moves is not limited to the area of the unit chip.

The non-destructive inspection system detects, via the probe array, charges in a second region of the semiconductor wafer (S730). According to an embodiment of the disclosure, the non-destructive inspection system may detect, via the probe array, charges in the second region on the second surface of the semiconductor wafer.

FIG. 8 is a cross-sectional view for explaining a method, performed by a non-destructive inspection system 800, of detecting an internal defect of a semiconductor wafer W while moving probes along a bottom surface of the semiconductor wafer W, according to an embodiment of the disclosure.

Referring to FIG. 8, the non-destructive inspection system 800 may include an electrode 810, an HV bias generator 820, an HV application probe 822, a light source 830, a plurality of probes 840, a plurality of ASICs 850, and a processor 860. The non-destructive inspection system 800 of FIG. 8 may include substantially the same configuration as the non-destructive inspection system 400 of FIG. 4, and thus descriptions that have already been provided above with respect to FIG. 4 may be omitted below.

In the structure of the non-destructive inspection system 800 shown in FIG. 8, the electrode 810 may be formed to cover a portion of a first surface W₁ of a semiconductor wafer W instead of the entire first surface W₁ on which light radiated by the light source 830 is incident. According to an embodiment of the disclosure, an area S_{c} of the electrode 810 may be equal to a size of a unit chip. The electrode 810 may be a common electrode commonly applied to the portion of the first surface W₁ of the semiconductor wafer W. The electrode 810 may serve as a conducting layer disposed on the first surface W₁ of the semiconductor wafer W.

The electrode 810 may be moved along the first surface W₁ of the semiconductor wafer W in a direction parallel to a longitudinal direction of the semiconductor wafer W. According to an embodiment of the disclosure, the non-destructive inspection system 800 may further include a device configured to move the electrode 810 in an X-axis or Y-axis direction. The device configured to move the electrode 810 may include a shaft to which the electrode 810 is coupled, and a motor for moving the electrode 810 along the shaft, but is not limited thereto.

According to an embodiment of the disclosure, the electrode 810 may be moved by a predetermined distance along the shaft. For example, the electrode 810 may be iteratively moved along the first surface W₁ of the semiconductor wafer W by a distance corresponding to an area of a unit chip.

The non-destructive inspection system 800 may include a predetermined number of probes 840 to detect charges in a portion of a surface of the semiconductor wafer W having the same size as the area S_{c} of the electrode 810. The probes 840 may be arranged to form a probe array.

The probes 840 may be disposed on a bottom surface, i.e., a second surface W₂, of the semiconductor wafer W in such a manner that the probes 840 are aligned with a position of the electrode 810. The probes 840 may be moved together with the electrode 810 so as to be aligned with a position to which the electrode 810 has been moved. According to an embodiment of the disclosure, the non-destructive inspection system 800 may further include a device configured to move the probes 840 in a direction parallel to the longitudinal direction of the semiconductor wafer W from a position that is spaced apart from the second surface W₂ of the semiconductor wafer W by a predetermined distance.

According to an embodiment of the disclosure, the probes 840 may be moved in the same direction and by the same distance that the electrode 810 is moved. For example, the probes 840 may be moved in a direction, i.e., an X-axis direction, parallel to the longitudinal direction of the semiconductor wafer W, or a Y-axis direction, and a distance by which the probes 840 are iteratively moved may correspond to an area of a unit chip.

As the position of the electrode 810 changes, the probes 840 may detect charges on the second surface W2 of the semiconductor wafer W while being moved along the semiconductor wafer W.

FIG. 9 is a flowchart illustrating operations of a method, performed by a non-destructive inspection system, of detecting an internal defect of a semiconductor wafer while moving along the bottom surface of the semiconductor wafer, according to an embodiment of the disclosure.

The non-destructive inspection system moves an electrode on the semiconductor wafer by a distance corresponding to an area of a unit chip (S910). According to an embodiment of the disclosure, the non-destructive inspection system may move the electrode by a predetermined distance from a first position on a first surface of the semiconductor wafer in a direction parallel to a longitudinal direction of the semiconductor wafer. For example, the distance by which the electrode is moved may correspond to an area of a unit chip of the semiconductor wafer, but is not limited thereto.

When the electrode is at the first position, the probes may be arranged at a position, aligned with the position of the electrode, on a second surface of the semiconductor wafer that is opposite to the first surface thereof. The probes may detect charges in a region on the second surface corresponding to the first position.

The non-destructive inspection system moves the plurality of probes in the same direction and by the same distance that the electrode is moved so as to be aligned with the position of the electrode (S920). According to an embodiment of the disclosure, the non-destructive inspection system may move the probes along the second surface of the semiconductor wafer in a direction parallel to the longitudinal direction of the semiconductor wafer. A distance by which the probes are moved may correspond to an area of a unit chip of the semiconductor wafer, but is not limited thereto.

When the position of the electrode changes from the first position on the first surface of the semiconductor wafer to a second position in operation S910, the probes may be moved to a position on the second surface of the semiconductor wafer corresponding to the second position.

The non-destructive inspection system detects charges in the semiconductor wafer via the plurality of probes (S930). When the probes are moved to a position corresponding to a second position to be aligned with the position of the electrode in operation S920, the probes may detect charges in a region on the second surface of the semiconductor wafer corresponding to the second position.

FIG. 10 illustrates a wafer feature map 1000 generated by a non-destructive inspection system to represent a location of an internal defect of a semiconductor wafer, according to an embodiment of the disclosure.

A processor of the non-destructive inspection system may generate the wafer feature map 1000 representing the absence or presence of defects in the semiconductor wafer and location of the defects based on digital signal values generated by ASICs. The ASICs may be respectively connected to a plurality of probes, may respectively compare amounts of charges detected by the probes with a predetermined threshold, and may convert the amounts of charges into digital signals. The processor may receive the digital signals, and may perform image processing using the digital signals to generate the wafer feature map 1000.

Referring to FIG. 10, intensities of pixels in the wafer feature map 1000 may be obtained by respectively converting the amounts of charges detected by the probes into digital signals via the ASICs, and imaging the digital signals via the processor. The pixels may respectively correspond to charge amount information detected by the probes. According to an embodiment of the disclosure, a unit chip image 1010 may be an image corresponding to an area over which a probe array including the probes detects charges at a time, but is not limited thereto.

A region of the wafer feature map 1000 displayed as black may be a normal region where an amount of charges greater than or equal to a predetermined threshold is detected on a surface of the semiconductor wafer. A region of the wafer feature map 1000 displayed as white may be a defect region 1020. The defect region 1020 may be a region with a defect related to at least one of a physical irregularity in the semiconductor wafer, a charging region on the surface of the semiconductor wafer, a change in a surface chemical, a change in semiconductor doping concentration, a contaminant in the semiconductor wafer, or a metallic or organic contaminant on the surface of the semiconductor wafer. By performing image processing using the digital signals received from the ASICs, the processor may generate the wafer feature map 1000 depicting a region having an amount of detected charges that is less than the predetermined threshold as being a white color.

The wafer feature map 1000 is not limited to that shown in FIG. 10. According to an embodiment of the disclosure, the processor may generate a wafer feature map showing a normal region of the semiconductor wafer in white and a defect region in black according to an image processing method.

The wafer feature map 1000 of FIG. 10 may be used to identify the absence or presence of a defect in a semiconductor wafer and also a location of the defect therein, thereby improving production yield and cost management in manufacturing a detector using a semiconductor wafer.

FIG. 11A illustrates an example in which energy spectrum data 1100 generated by a non-destructive inspection system is displayed on corresponding regions of a semiconductor wafer W, according to an embodiment of the disclosure, and FIG. 11B illustrates energy spectrum data 1110 of each unit chip shown in FIG. 11A.

Referring to FIG. 11A, the non-destructive inspection system may generate the energy spectrum data 1100 representing the degree of response to a photon having a specific energy band in the semiconductor wafer W. According to an embodiment of the disclosure, a processor of the non-destructive inspection system may generate the energy spectrum data 1110 representing the degree of response to a photon per unit chip area of the semiconductor wafer W. While FIG. 11A shows, for convenience of description, that the energy spectrum data 1110 generated per unit chip area of the semiconductor wafer is visually displayed in a corresponding unit chip region, the energy spectrum data 1100 is not displayed in an actual semiconductor wafer W. The display (e.g., display 170 of FIG. 1) may display the energy spectrum data 1100 in such a manner that the energy spectrum data 1100 overlaps corresponding regions of the semiconductor wafer W where information about energy response is acquired.

In this case, the energy spectrum data 1110 might not necessarily be generated per unit chip area of the semiconductor wafer W. According to an embodiment of the disclosure, the processor may also generate, for each pixel, energy spectrum data representing the degree of response to a photon having a specific energy band.

Furthermore, according to another embodiment of the disclosure, the processor may generate energy spectrum data of the entire semiconductor wafer W by summing all energy spectrum data acquired on a pixel-by-pixel basis. FIG. 11B is a graph illustrating the energy spectrum data 1110 generated per unit chip or pixel. When light is received from a light source having a mono energy band, energy response to a photon may vary across a unit chip or pixel of a semiconductor wafer. For example, when light is radiated by a light source having an energy band with a peak energy at Eₖ (kiloelectron volts (keV)), a photon having a maximum size at Eₖ (keV) may be detected in a unit chip or pixel of the semiconductor wafer. In general, a range of an energy band having a peak in energy spectrum data may be inversely proportional to the quality of a semiconductor wafer. In other words, as the range of an energy band having a peak in energy spectrum data narrows, the quality of a semiconductor wafer improves.

According to the embodiment of the disclosure described with reference to FIGS. 11A and 11B, the non-destructive inspection system may generate an energy spectrum for each unit chip or pixel of the semiconductor wafer W and visually display the energy spectrum on the display 170, thereby allowing a user to intuitively identify the degree of energy response to a light source having a specific energy band and increasing user convenience. Furthermore, the quality of semiconductor wafers may be determined in advance before manufacturing a detector by using the semiconductor wafers, thereby reducing the manufacturing costs and improving production yield.

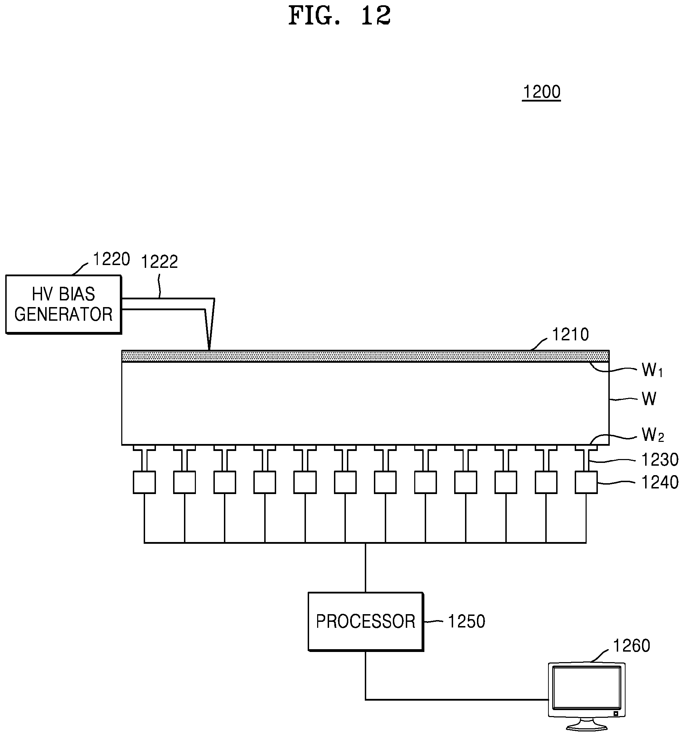

FIG. 12 is a cross-sectional view illustrating a configuration of a non-destructive inspection system 1200 according to an embodiment of the disclosure.

Referring to FIG. 12, the non-destructive inspection system 1200 may include an electrode 1210, an HV bias generator 1220, an HV application probe 1222, a plurality of probes 1230, a plurality of ASICs 1240, and a processor 1250. The non-destructive inspection system 1200 may further include a display 1260. The non-destructive inspection system 1200 of FIG. 12 may not include a light source as compared to the non-destructive inspection systems 300-1, 300-2, 400, and 800 respectively described with reference to FIGS. 3A, 3B, 4, and 8.

The non-destructive inspection system 1200 may apply, via the HV bias generator 1220, a high voltage to the electrode 1210 disposed on a first surface W₁ of a semiconductor wafer W. The HV application probe 1222 may also be used for application of a high voltage.

When the high voltage is applied to the electrode 1210, an electric field may be generated within the semiconductor wafer W. The probes 1230 may be disposed on a second surface W₂ of the semiconductor wafer W and detect a leakage current flowing on the second surface W₂. In this case, the leakage current may refer to a dark current because the leakage current flows on a surface of the semiconductor wafer when the semiconductor wafer is not irradiated by light from a light source.

The ASICs 1240 may compare the amount of leakage current detected by the probes 1230 with a predetermined threshold, and output a digital signal as a result of the comparison. While FIG. 12 shows that the ASICs 1240 are configured as a plurality of ASICs respectively corresponding to the probes 1230, embodiments of the disclosure are not limited thereto. According to an embodiment of the disclosure, the ASICs 1240 may be configured as a single ASIC chip.

The processor 1250 may determine the relationship between the current detected in the absence of a light source and a voltage based on a current-voltage (I-V) curve, and identify a location where the leakage current is detected. In detail, the processor 1250 may identify a position of a probe that detects the leakage current from among the probes 1230 by analyzing the digital signals received from the ASICs 1240, and identify the location where the leakage current is detected.

According to an embodiment of the disclosure, the processor 1250 may generate an image using the digital signals generated by the ASICs 1240 by using a general-purpose image processing method. For example, the processor 1250 may generate a feature map showing pixels corresponding to a region where the leakage current flows on the surface of the semiconductor wafer W in white, and pixels corresponding to a normal region in black.

The display 1260 may display the feature map for the semiconductor wafer W, which is generated by the processor 1250.

According to the embodiment of the disclosure shown in FIG. 12, the non-destructive inspection system 1200 may detect the leakage current on the surface of the semiconductor wafer W without irradiation of light via a light source to generate a feature map, thereby identifying the absence or presence of a defect in the semiconductor wafer W as well as a location of the defect therein. Thus, when the semiconductor wafer W is inspected by the non-destructive inspection system 1200, quality control and production yield may be improved during the subsequent manufacturing of a detector using the semiconductor wafer W.

The embodiments of the disclosure may be implemented as a software program including instructions stored in a non-transitory computer-readable storage medium.

A computer refers to a device configured to retrieve an instruction stored in a non-transitory computer-readable storage medium and to operate, in response to the retrieved instruction, and may include a non-destructive inspection system according to embodiments of the disclosure.

The computer-readable storage medium may be provided in the form of a non-transitory storage medium. In this regard, the term "non-transitory" means that the storage medium does not include a signal per se and is instead tangible, and the term does not distinguish between data that is semi-permanently stored and data that is temporarily stored in the storage medium.

In addition, the non-destructive inspection system and method of operating the same according to embodiments of the disclosure may be provided in the form of a computer program product. The computer program product may be traded, as a product, between a seller and a buyer.

The computer program product may include a software program and a computer-readable storage medium having stored thereon the software program. For example, the computer program product may include a product (e.g., a downloadable application) in the form of a software program electronically distributed by a manufacturer of the non-destructive inspection system or through an electronic market (e.g., Google Play Store™ and App Store™). For such electronic distribution, at least a part of the software program may be stored on the storage medium or may be temporarily generated. In this case, the storage medium may be a storage medium of a server of the manufacturer, a server of the electronic market, or a relay server for temporarily storing the software program.

In a system including a server and a device (e.g., the non-destructive inspection system), the computer program product may include a storage medium of the server or a storage medium of the device. Alternatively, in a case where a third device (e.g., a smartphone) that communicates with the server or the device is present, the computer program product may include a storage medium of the third device. Alternatively, the computer program product may include a software program that is transmitted from the server to the device or the third device or that is transmitted from the third device to the device.

In this case, one of the server, the device, and the third device may execute the computer program product, thereby performing the method according to embodiments of the disclosure. Alternatively, at least two of the server, the device, and the third device may execute the computer program product, thereby performing the method according to embodiments of the disclosure in a distributed manner.

For example, the server (e.g., a cloud server, an artificial intelligence (Al) server, or the like) may execute the computer program product stored in the server, and may control the device communicating with the server to perform the method according to embodiments of the disclosure.

As another example, the third device may execute the computer program product, and may control the device communicating with the third device to perform the method according to embodiments of the disclosure.

In a case where the third device executes the computer program product, the third device may download the computer program product from the server, and may execute the downloaded computer program product. Alternatively, the third device may execute the computer program product that is pre-loaded therein, and may perform the method according to the embodiments.

The above-described embodiments of the disclosure may be embodied in the form of a computer-readable recording medium for storing computer executable instructions and data. The instructions may be stored in the form of program codes and, when executed by a processor, may cause the processor to perform a certain operation by generating a certain program module. Also, when executed by a processor, the instructions may cause the processor to perform certain operations of the embodiments of the disclosure.

While embodiments of the disclosure have been particularly shown and described with reference to the accompanying drawings, it will be understood by those of ordinary skill in the art that various changes in form and details may be made thereto without departing from the spirit and scope of the disclosure as defined by the appended claims. The embodiments of the disclosure should be considered in descriptive sense only and not for purposes of limitation

## Claims

1. A inspection system for detecting a defect in a semiconductor wafer comprising a compound semiconductor material, the inspection system comprising:
an electrode provided on a first surface of the semiconductor wafer;
a voltage source configured to generate an electric field by applying a high voltage bias to the semiconductor wafer via the electrode;
a light source configured to irradiate the first surface of the semiconductor wafer with light to generate charges in the semiconductor wafer;
a plurality of probes provided on a second surface of the semiconductor wafer and configured to respectively detect the charges based on movement of electrons and holes generated in the semiconductor wafer by the light radiated by the light source; and
a controller configured to:
measure amounts of the charges respectively detected by the plurality of probes,
compare the amounts of the charges with a predetermined threshold; and
detect a defect in the semiconductor wafer based on the comparison of the amounts of the charges with the predetermined threshold.

2. The inspection system of claim 1, wherein the controller comprises:
an application specific integrated circuit (ASIC) configured to:
measure the amounts of the charges on a pixel-by-pixel basis;
compare the amounts of the charges with the predetermined threshold ; and
generate digital signals based on the comparison of the amounts of the charges with the predetermined threshold; and
a processor configured to generate a wafer feature map identifying a location of the defect in the semiconductor wafer based on the digital signals generated on the pixel-by-pixel basis.

3. The inspection system of claim 1, wherein the plurality of probes is configured to have a predetermined number of probes configured to detect the charges in a region corresponding to an area of a unit chip of the semiconductor wafer, and
wherein the predetermined number of probes constitutes a probe array.

4. The inspection system of claim 3, wherein the probe array is configured to detect the charges based on being moved along the second surface of the semiconductor wafer in a direction parallel to a longitudinal direction of the semiconductor wafer.

5. The inspection system of claim 1, wherein the electrode has a size corresponding to an area of a unit chip of the semiconductor wafer, and
wherein the plurality of probes is configured to have a predetermined number of probes to detect the charges in a region corresponding to the area of the unit chip.

6. The inspection system of claim 5, wherein the electrode is configured to be moved on the first surface of the semiconductor wafer by a distance corresponding to the area of the unit chip in a direction parallel to a longitudinal direction of the semiconductor wafer, and
wherein the plurality of probes is configured to detect the charges on the second surface of the semiconductor wafer based on being moved in a same direction and by a same distance that the electrode is moved to be aligned with a position of the electrode.

7. The inspection system of claim 1, wherein the controller is further configured to:
generate energy spectrum data representing a degree of a response to a photon having a specific energy band.

8. A inspection method of detecting a defect in a semiconductor wafer comprising a compound semiconductor material, the inspection method comprising:
irradiating a first surface of the semiconductor wafer with light;
generating an electric field in the semiconductor wafer by applying a high voltage (HV) bias via an electrode provided on the first surface of the semiconductor wafer;
detecting, via a plurality of probes, charges based on movement of electrons and holes generated in the semiconductor wafer;
measuring amounts of the charges;
comparing the amounts of the charges with a predetermined threshold; and
detecting a defect in the semiconductor wafer based on the comparing the amounts of the charges with the predetermined threshold.

9. The inspection method of claim 8, wherein the measuring amounts of the detected charges comprises measuring amounts of the detected charges on a pixel-by-pixel basis, and
wherein the detecting the defect in the semiconductor wafer comprises:
generating digital signals based on the comparing the amounts of the charges with the predetermined threshold; and
generating a wafer feature map identifying a location of the defect in the semiconductor wafer based on the digital signals.

10. The inspection method of claim 8, wherein the plurality of probes includes a predetermined number of probes configured to detect the charges in a region corresponding to an area of a unit chip of the semiconductor wafer, and
wherein the predetermined number of probes constitutes a probe array.

11. The inspection method of claim 10, wherein the detecting the charges comprises:
detecting a first subset of the charges in a first region of the semiconductor wafer;
moving the probe array to a second region of a second surface of the semiconductor wafer in a direction parallel to a longitudinal direction of the semiconductor wafer; and
detecting a second subset of the charges in the second region of the semiconductor wafer.

12. The inspection method of claim 8, wherein the electrode has a size corresponding to an area of a unit chip of the semiconductor wafer, and
wherein the plurality of probes includes a predetermined number of probes configured to detect the charges in a region corresponding to the area of the unit chip.

13. The inspection method of claim 12, wherein the detecting the charges comprises:
moving the electrode on the first surface of the semiconductor wafer by a distance corresponding to the area of the unit chip in a direction parallel to a longitudinal direction of the semiconductor wafer;
moving the plurality of probes in a same direction and by a same distance that the electrode is moved to be aligned with a position of the electrode; and
detecting the charges in the semiconductor wafer via the plurality of probes based on moving the plurality of probes.

14. The inspection method of claim 8, further comprising:
generating energy spectrum data representing a degree of an energy response in a specific energy band.

15. A computer program product comprising a computer-readable storage medium, wherein the computer-readable storage medium includes instructions for performing a inspection method of detecting a defect in a semiconductor wafer comprising a compound semiconductor material comprising:
irradiating a first surface of the semiconductor wafer with light;
generating an electric field in the semiconductor wafer by applying a high voltage (HV) bias via an electrode provided on the first surface of the semiconductor wafer;
detecting, via a plurality of probes, charges based on movement of electrons and holes generated in the semiconductor wafer;
measuring amounts of the charges;
comparing the amounts of the charges with a predetermined threshold; and
detecting a defect in the semiconductor wafer based on the comparing the amounts of the charges with the predetermined threshold.
